# EUROPEAN PATENT SPECIFICATION

(11) **EP 2 180 761 B1**
(45) Date of publication and mention of the grant of the patent: **01.02.2012**
(21) Application number: 07792378.7
(22) Date of filing: 10.08.2007
(51) Int. Cl.: H05B 33/04, G09F 9/30, H01L 27/32, H01L 51/50, H05B 33/02, H05B 33/10

(54) **ORGANIC ELECTROLUMINESCENCE DISPLAY PANEL AND PROCESS FOR PRODUCING THE SAME**
ORGANISCHER ELEKTROLUMINESZENZANZEIGESCHIRM UND HERSTELLUNGSPROZESS DAFÜR
PANNEAU D'AFFICHAGE À ÉLECTROLUMINESCENCE ORGANIQUE ET SON PROCÉDÉ DE FABRICATION

(43) Date of publication of application: 28.04.2010
(73) Proprietor: Pioneer Corporation, Kanagawa 212-0031 (JP)
(72) Inventor: YOSHIZAWA, Tatsuya, Tsurugashima-shi Saitama 350-2288 (JP); OHSHITA, Isamu, Tsurugashima-shi Saitama 350-2288 (JP)
(74) Representative: Haley, Stephen
(86) International application number: PCT/JP2007/065733
(87) International publication number: WO 2009/022380

(56) References cited:
- EP-A2- 1 344 649
- JP-A- 2000 105 557
- JP-A- 2003 338 370
- JP-A- 2004 303 643
- JP-A- 2005 222 807
- JP-A- 2005 354 305
- JP-A- 2006 146 214
- JP-A- 2006 196 466

## Description

The present invention relates to an organic electroluminescent display panel comprising a film moisture-proof substrate having a built-in organic electroluminescent element, and a manufacturing method thereof.

In prior art, EL light-emitting sheets used for a flat-surface backlight have been incapable of forming a light-emitting surface of a curved shaped with the sheet shape as is, requiring a portion of the curved surface to be finished as a flat surface. Accordingly, a thin curved-surface light-emitting panel that uses an EL light-emitting sheet and its manufacturing method employ a method of using a frame to support the end portions of the EL light-emitting sheet to prevent shrinkage on curing in an attempt to correct the EL light-emitting sheet to a predetermined shape (see JP, A, 2000-105557). According to such a well-known prior art, shape changes such as warping are prevented from occurring on a thin curved-surface light-emitting panel that uses the EL light-emitting sheet, to the extent possible, thereby preventing the occurrence of non-uniform brightness. In another prior art document, EP 1344649, a technique is described in which a display substrate is held in a guiding groove.

### Problem to be Solved by the Invention

Nevertheless, while the above-described EL light-emitting sheet is corrected by using the above-mentioned frame to support the end portions and thus form a desired curved surface having elasticity, the possibility exists that humidity, moisture, oxygen, and the like may penetrate from the end portions in a case where space forms between the end portions and the frame.

The above-described problem is given as one example of the problems that are to be solved by the present invention.

### Means for Solving the Problem

In order to achieve the above-mentioned object, according to a first aspect, there is provided an organic electroluminescent display panel, comprising: a frame body on which a desired reference surface is formed; a film moisture-proof substrate having a built-in thin-film organic electroluminescent element group; and a moisture-proof fixing means for fixing a front surface of the film moisture-proof substrate to the frame body while the front surface of the film moisture-proof substrate is in close contact with the reference surface, and for covering at least an end portion of the film moisture-proof substrate, characterized in that: the moisture-proof fixing means includes: an adhesive for fixing the film moisture-proof substrate to the frame body while the film moisture-proof substrate is in close contact with the reference surface; and a pressing and fixing frame that presses against one surface of the film moisture-proof substrate so that the film moisture-proof substrate comes in close contact with the reference surface.

In order to achieve the above-mentioned object, according to a second aspect, there is provided a manufacturing method of an organic electroluminescent display panel comprising the steps of: a step for fixing a front surface of a film moisture-proof substrate having a built-in thin-film organic electroluminescent element group to a frame body in a state that a pressing and fixing frame presses against one surface of said film moisture-proof substrate so that said film moisture-proof substrate comes in close contact with a reference surface formed on a frame body, while covering at least an end portion of the film moisture-proof substrate by using the pressing and fixing frame in a pressing state and an adhesive.

### BRIEF DESCRIPTION OF THE DRAWINGS

FIG. 1 is a perspective view illustrating a configuration example of an organic EL display panel of comparative example 1.
FIG. 2 is an exploded perspective view illustrating a configuration example of the organic EL display panel of FIG. 1, as assembled.
FIG. 3 is a partial cross-sectional view illustrating an example of the film moisture-proof substrate fixed to the frame body of FIG. 2.
FIG. 4 is a partial cross-sectional view illustrating an alternative embodiment of the film moisture-proof substrate fixed to the frame body of FIG. 3. FIG. 5 is an exploded perspective view illustrating a configuration example of an organic EL display panel of embodiment 1, as assembled.
FIG. 6 is a partial cross-sectional view illustrating an example of the film moisture-proof substrate and the fixing frame fixed to the frame body of FIG. 5.
FIG. 7 is a partial cross-section view illustrating an alternative embodiment of the film moisture-proof substrate and the fixing frame fixed to the frame body of FIG. 6.
FIG. 8 is a perspective view illustrating a partial process example of assembling the organic EL display panel of comparative example 2.
FIG. 9 is a perspective view illustrating a partial process example of assembling the organic EL display panel of comparative example 2. FIG. 10 is a perspective view illustrating a partial process example of assembling the organic EL display panel of alternative example 1 of comparative example 2.
FIG. 11 is a perspective view illustrating a partial process example of assembling the organic EL display panel of alternative example 1 of comparative example 2.
FIG. 12 is a cross-sectional view illustrating a second cross-sectional configuration example of the fixing frames of FIG. 10 and FIG. 11.
FIG. 13 is a cross-sectional view illustrating a second cross-sectional configuration example of the fixing frames of FIG. 10 and FIG. 11.
FIG. 14 is a perspective view illustrating an example of fixing the end portions of the film moisture-proof substrate using the fixing frames.
FIG. 15 is a perspective view illustrating a partial process example of assembling the organic EL display panel of alternative example 2 of comparative example 2.
FIG. 16 is a cross-sectional view illustrating a configuration example of the fixing frames of FIG. 15. FIG. 17 is a perspective view illustrating another example of a part of the process of assembling the organic EL display panel.
FIG. 18 is a perspective view illustrating a partial process example of assembling the organic EL display panel of comparative example 3.
FIG. 19 is a perspective view illustrating a partial process example of assembling the organic EL display panel of comparative example 3.
FIG 20 is a cross-sectional configuration example of the fixing frames of FIG. 19.
FIG. 21 is a perspective view illustrating a partial process example of assembling the organic EL display panel of comparative example 4.
FIG. 22 is a perspective view illustrating a partial process example of assembling the organic EL display panel of comparative example 4.
FIG. 23 is a perspective view illustrating a partial process example of assembling the organic EL display panel of an alternative example of comparative example 4.
FIG. 24 is a perspective view illustrating a partial process example of assembling the organic EL display panel of an alternative example of comparative example 4.
FIG. 26 is a cross-sectional view illustrating a configuration example of a portion of the organic EL display panel of alternative example 1 of each of the above embodiments and examples.
FIG. 27 is a cross-sectional view illustrating a configuration example of a portion of the organic EL display panel of alternative example 2 of each of the above embodiments and examples.
FIG. 28 is partial cross-sectional view illustrating an alternative example of the film moisture-proof substrate of FIG. 3.

### BEST MODE FOR CARRYING OUT THE INVENTION

The following describes embodiments of the present invention and comparative example with reference to accompanying drawings.

### Comparative Example 1

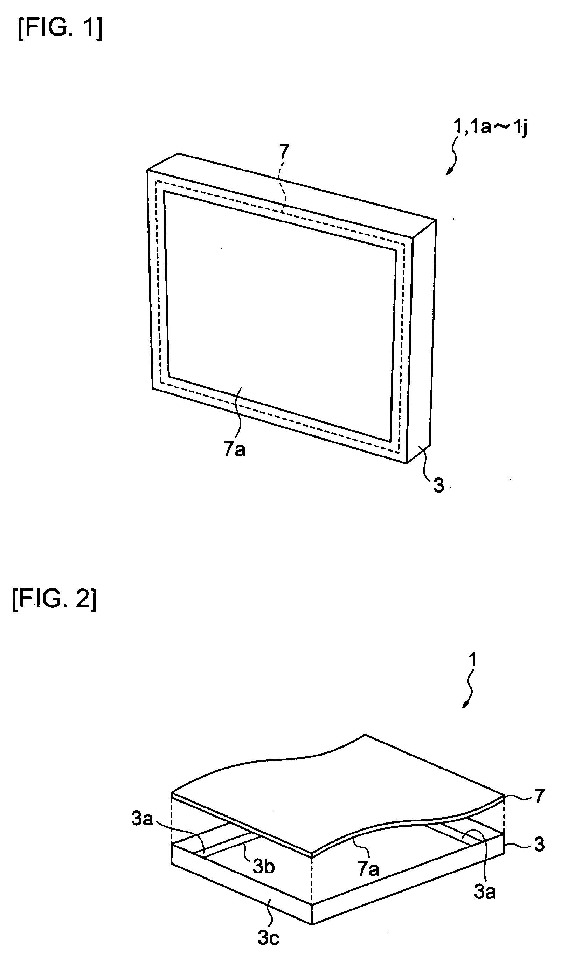

FIG. 1 is a perspective view illustrating a configuration example of an organic electroluminescent display panel of a comparative example 1 which does not form part of the present invention.

The orgnanic electroluminescent display panel 1 is in appearance comprises a frame body 3 and a film moisture-proof substrate 7. In the following description, "organic electroluminescent display panel" is abbreviated as "organic EL display panel". This film moisture-proof substrate 7 comprises multiple rows of built-in-film- organic electroluminescent elements, for example. Here, the "thin film organic electroluminescent elements," unlike distributed organic electroluminescent elements, form an organic electroluminescent layer via a predetermined film formation process, for example.

The frame body 3 is an external member constituting a housing of the organic EL display panel 1. On the front surface of this frame body 3 is formed an opening, and this opening comprises a display surface 7a of the film moisture-proof substrate 7. That is, when the film moisture-proof substrate 7 is actuated, light is emitted from the display surface 7a by the action of the distributed organic electroluminescent elements, and a predetermined image is displayed.

FIG. 2 is an exploded perspective view illustrating a configuration example of the organic EL display panel 1 of FIG. 1, as assembled. In this FIG. 2, the organic EL display panel 1 is disassembled with the display surface 7a facing downward as an example, illustrating a simplified view that focuses on the members related to the example. Note that, in FIG. 2, the organic EL display panel 1 may be disassembled with the display surface 7a facing upward.

The organic EL display panel 1 mainly comprises the frame body 3 and the substrate 7. This substrate 7 is a moisture-proof substrate that is a film having multiple rows of organic electroluminescent elements as described above and is sealed by a resin such as plastic. In the following description, the substrate 7 is referred to as the "film moisture-proof substrate 7." This film moisture-proof substrate 7 has a built-in group of thin-film organic electroluminescent elements.

The frame body 3 is formed into a thin box shape having an opening on the bottom, for example, and the display surface 7a of the film moisture-proof substrate 7 is exposed from this opening. That is, the frame body 3 comprises a side portion 3c that forms four surfaces along the thickness direction of organic EL display panel 1, and a frame portion 3b of a predetermined thickness that is formed along the outer edge of the organic EL display panel 1 when viewed from the display surface 7a. A reference surface 3a having a function such as
described below is formed on the surface on the backside of the front surface (hereinafter "rear surface") of the frame portion 3b. This reference surface 3a presses against the film moisture-proof substrate 7 when the organic EL display panel 1 is assembled, and is used as a reference for correcting the film moisture-proof substrate 7 to a desired shape.

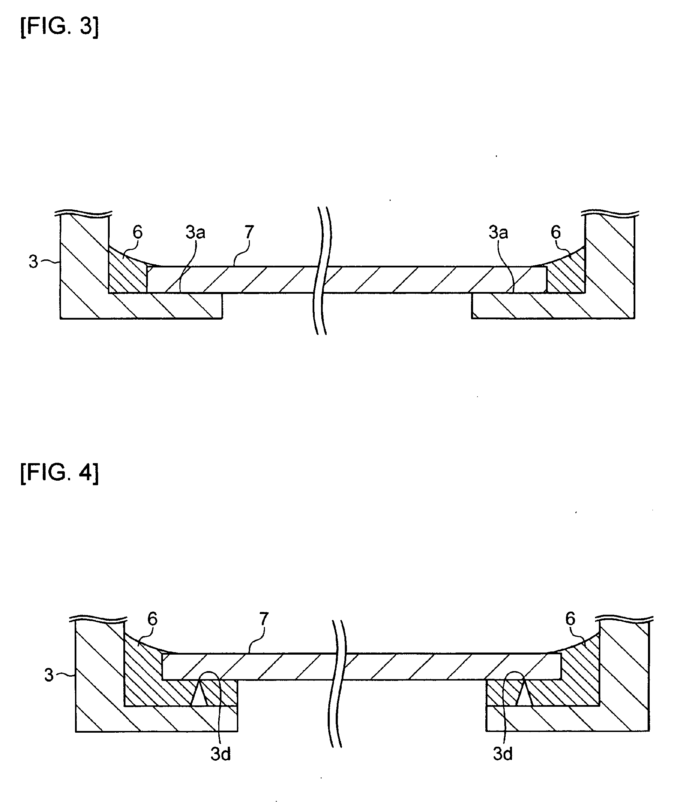

FIG. 3 is a partial cross-sectional view showing an example of the film moisture-proof substrate 7 fixed to the frame body 3 of FIG. 2.

This film moisture-proof substrate 7 is fixed to the frame body 3 by a moisture-proof adhesive 6 (equivalent to a moisture-proof fixing means), with the front surface of the film moisture-proof substrate 7 in close contact with the reference surface 3a. This moisture-proof adhesive 6 covers the end portions of the film moisture-proof substrate 7. The "end portions of the film moisture-proof substrate 7" include not only the end surfaces that constitute the thickness of the film moisture-proof substrate 7, but also a part of the surrounding front and rear surfaces of the film moisture-proof substrate 7.

The moisture-proof adhesive 6 is an adhesive for securing the film moisture-proof substrate 7 to the frame body 3 with the film moisture-proof substrate 7 in close contact with the reference surface, for example. Specifically, the film moisture-proof substrate 7 is disposed so that the outer edge portions of the four sides thereof are in close contact with the reference surface 3a provided on the rear surface of the four sides of the frame body 3. The film moisture-proof substrate 7 is fixed to the frame body 3 by the moisture-proof adhesive 6 at fixing locations of the frame body 3.

The moisture-proof adhesive 6 is made of a moisture-proof material, and has characteristics such as described later. First, since the distributed electroluminescent element is generally an inorganic material, for example, the required moisture-proof function differs from that of the organic electroluminescent element. The moisture permeability of general resin is approximately 1 to 10 [g/m² per day], and the moisture permeability of a resin substrate for an LCD (liquid crystal display) having an added moisture-proof barrier film is approximately 0.1 [g/m² per day] or less. Further, the moisture permeability required in a thin-film organic electroluminescent element susceptible to humidity, moisture, and oxygen requires a high moisture-proof capability of an even lower numerical value, such as that equivalent to the measurement threshold of the Mocon method, i.e., approximately 0.001 [g/m² per day (g/m² per d)] or less. Note that the moisture permeability (gas barrier characteristics) of a glass substrate is approximately 10⁻³ to 10⁻⁶ (g/m² per day).

According to this example, an acrylic UV curing adhesive is employed as the above-described moisture-proof adhesive 6, for example, and the moisture permeability of the end portions of the film moisture-proof substrate 7 sealed by this moisture-proof adhesive is 10⁻³ [g/m² per day (g/m² per d)] or less, for example. Note that the moisture-proof adhesive 6 is not limited to such an acrylic UV curing resin (adhesive), allowing use of resins (adhesives), such as an acrylic or epoxy, that cure by means such as ultraviolet light or heat.

In a case where the moisture-proof adhesive 6 employs a joining material such as an epoxy, the joining material is a member through which ultraviolet light passes, for example. A fixing frame 9 described after, etc., is also made of a material that does not block the transmission of ultraviolet light, for example. Examples of material of the fixing frame 9 include plastic and metal. Additionally, in a case where a trim of a size adequate for preventing the penetration of moisture from the end portions of the film moisture-proof substrate 7 is employed, the locations covered and fixed by the moisture-proof adhesive 6 may be a fraction thereof. Here, the term "trim" refers to the width from the moisture-proof substrate end portion to a component member such as the organic functional layer or organic insulating film of the organic EL susceptible to moisture or oxygen.

With this arrangement, the film moisture-proof substrate 7 exhibits a correction effect of being corrected to a desired shape that conforms to the reference surface 3a. In addition, since the moisture-proof adhesive 6 has moisture-proof characteristics as described above, the moisture-proof adhesive 6 exhibits a moisture-proof effect capable of effectively blocking off the thin-film organic electroluminescent elements susceptible to humidity and moisture from humidity, moisture, and oxygen. In addition, this moisture-proof adhesive 6 exhibits an anti-stripping effect capable of preventing a portion thereof from being stripped from the end portions of the film moisture-proof substrate 7.

FIG. 4 is a partial cross-sectional view illustrating an alternative example of the film moisture-proof substrate 7 fixed to the frame body 3 of FIG. 3.

In FIG. 4, while the frame body 3, the film moisture-proof substrate 7, and the adhesive 6 are substantially the same as those shown in FIG. 3, the correction method of the film moisture-proof substrate 7 is different. Specifically, a reference point 3d is formed on the rear surface of the frame body 3. Note that this reference point 3d may not only be formed into a point shape, but may also be formed into a linear shape, either partially or fully along the frame portion 3b on the rear surface thereof, for example. In a case that a plurality of reference points 3d are provided, a plane including the plurality of reference points 3d becomes a reference surface that functions equivalent to the reference surface 3a.

An example of the manufacturing method of the organic EL display panel 1 having such a configuration will now be described with reference to FIGS. 1 to 4. According to this manufacturing method, the front surface of the film moisture-proof substrate 7 having the built-in thin-film organic electroluminescent element group is fixed to the frame body 3 while in close contact with the reference surface 3a formed on the frame body 3 using the moisture-proof fixing means 6, while covering the end portions of the film moisture-proof substrate 7 with the moisture-proof fixing means 6.

The organic EL display panel 1 of the above example comprises the frame body 3 on which the desired reference surface 3a is formed, the film moisture-proof substrate 7 having the built-in thin-film organic electroluminescent element group, and the moisture-proof fixing means 6 that fixes the front surface of the film moisture-proof substrate 7, which is positioned in close contact with the reference surface 3a, to the frame body 3 and covers at least an end portion of the film moisture-proof substrate 7.

In the manufacturing method of the organic EL display panel 1 of the above embodiment, the front surface of the film moisture-proof substrate 7 having the built-in thin-film organic electroluminescent element group is fixed to the frame body 3 while in close contact with the reference surface 3a formed on the frame body 3 using the moisture-proof fixing means 6, while covering at least an end portion of the film moisture-proof substrate 7 with the moisture-proof fixing means 6.

With this arrangement, since the front surface of the film moisture-proof substrate 7 is in close contact with the reference surface 3a of the frame body 3, the film moisture-proof substrate 7 is corrected to a shape that conforms with the reference surface 3, even if temporarily deformed. In addition, since the film moisture-proof substrate 7 is moisture-proof itself and the end portions thereof are covered by the moisture-proof fixing means 6, the film moisture-proof substrate 7 is capable of effectively inhibiting the penetration of humidity, moisture, and oxygen from the end portions thereof. Thus, since the film moisture-proof substrate 7 is not susceptible to damage by humidity, moisture, or oxygen, even when having built-in thin-film organic electroluminescent elements, it is possible to prevent the formation of so-called dark spots when light is emitted.

In the organic EL display panel 1 of the above example, in addition to the above configuration, the moisture-proof fixing means 6 is the adhesive 6 for fixing the film moisture-proof substrate 7 to the frame body 3 while the film moisture-proof substrate 7 is in close contact with the reference surface 3a.

With this arrangement, the film moisture-proof substrate 7 is not only corrected to a shape as described above, but enables establishment of both a fixing function for fixing itself to the frame body 3 by the adhesive 6 and a moisture-proof function of the end portions thereof.

### Embodiment 1

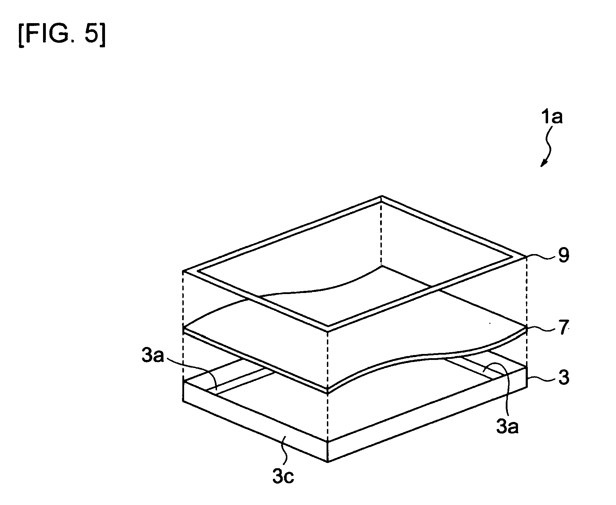

FIG. 5 is an exploded perspective view illustrating a configuration example of an organic EL display panel 1a of embodiment 1, as assembled. In FIG. 5, the organic EL display panel 1 is disassembled with the display surface 7a facing downward, illustrating a simplified view that focuses on the members related to the embodiment.

The organic EL display panel 1a of embodiment 2 has substantially the same configuration and behaves in substantially the same manner as comparative example 1. Thus, the same reference numerals as those in FIGS. 1 to 4 of comparative example 1 denote the same components and behavior, and descriptions thereof will be omitted. The following description will focus on the differences between embodiment 1 and comparative example 1.

While in comparative example 1 the film moisture-proof substrate 7 is placed in close contact with the reference surface 3 to correct the film moisture-proof substrate 7 to a desired shape, and is fixed to the frame body 3 using the moisture-proof adhesive 6, in embodiment 1 the configuration is as follows. That is, according to embodiment 1, the film moisture-proof substrate 7 is placed in close contact with a reference surface 3a, the fixing frame 9 is pressed against the film moisture-proof substrate 7 from the rear surface thereof to correct the film moisture-proof substrate 7 in accordance with the shape of the reference surface 3a and the fixing frame 9, and the film moisture-proof substrate 7 and the fixing frame 9 are then fixed to the frame body 3 using the moisture-proof adhesive 6. Note that the reference surface 3a may be formed on the fixing frame 9 rather than or in addition to the frame body 3.

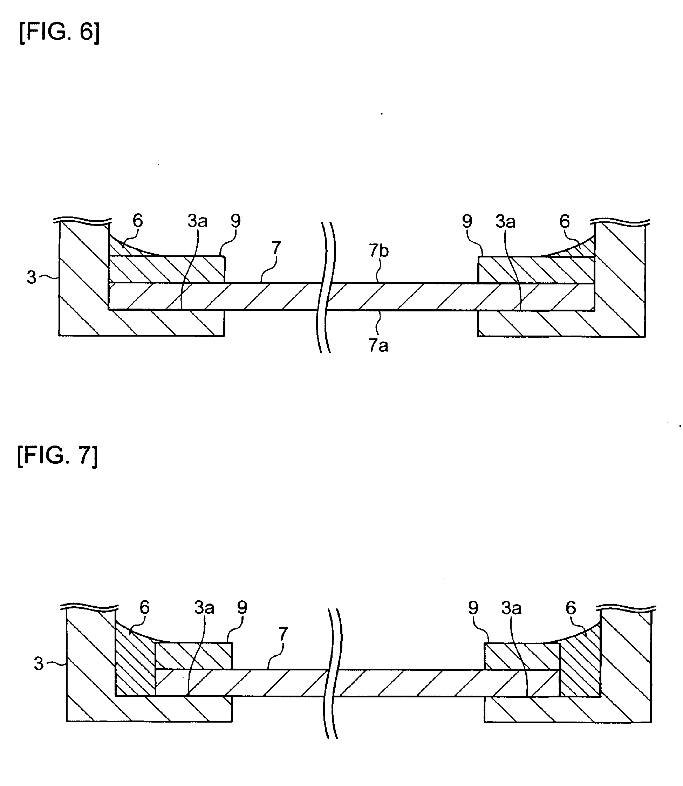

FIG. 6 is a partial cross-sectional view illustrating an example of the film moisture-proof substrate 7 and the fixing frame 9 fixed to the frame body 3 of FIG. 5. Since the configuration shown in FIG. 6 is substantially the same as the configuration shown in FIG. 3 of comparative example 1, the following description will focus on the differences therebetween.

The configuration shown in FIG. 6, in addition to the configuration shown in FIG. 3, further comprises the fixing frame 9. This fixing frame 9 is equivalent to a pressing and fixing frame, and is pressed against a rear surface 7b of the film moisture-proof substrate 7 so that the film moisture-proof substrate 7 comes in close contact with the reference surface 3. This fixing frame 9 is disposed so that the film moisture-proof substrate 7 is pressed against the reference surface 3a from one surface (hereinafter represented by the rear surface 7b) of the film moisture-proof substrate 7.

The film moisture-proof substrate 7 is fixed to the frame body 3 by the moisture-proof adhesive 6 with its rear surface 7b pressed against the reference surface 3a by the fixing frame 9. The end surfaces of the film moisture-proof substrate 7 and the fixing frame 9 contact the rear surface of the frame body 3 and are fixed to the frame body 3 from the upper surface of the fixing frame 9 by the moisture-proof adhesive 6, thereby inhibiting penetration of humidity, moisture, and oxygen from the end portions thereof.

In the organic EL display panel 1a of the above embodiment, the moisture-proof fixing means includes the pressing and fixing frame 9 (equivalent to the fixing frame) that presses the film moisture-proof substrate 7 from the one surface 7b thereof so that the film moisture-proof substrate 7 comes in close contact with the reference surface 3, using the adhesive 6.

With this arrangement, the film moisture-proof substrate 7 is fixed to the frame body 3 in a state corrected by not only the reference surface 3a but also the pressing and fixing frame 9, thereby correcting the film moisture-proof substrate 7 more closely to a shape that conforms with the reference surface 3a.

FIG. 7 is a partial cross-sectional view illustrating an alternative embodiment of the film moisture-proof substrate 7 and the fixing frame 9 fixed to the frame body 3 of FIG. 6. The following description of FIG. 7 will focus on the differences between FIG. 6 and embodiment 2.

According to the configuration shown in FIG. 7, the configuration differs from that shown in FIG. 6 in that each end portion of the film moisture-proof substrate 7 and the fixing frame 9 are not in contact with the rear surface of the fixing body 3, and the moisture-proof adhesive 6 is filled in each end portion of the film moisture-proof substrate 7, the fixing frame 9, and the frame body 3 When the moisture-proof adhesive 6 is thus filled, the moisture-proof capability increases further than in a case where each end portion is sealed as shown in FIG. 6, and the moisture-proof adhesive 6 more readily enters each end portion in a sufficient manner, thereby causing the film moisture-proof substrate 7 to be more reliably fixed to the frame body 3 by the moisture-proof adhesive 6.

### Comparative Example 2

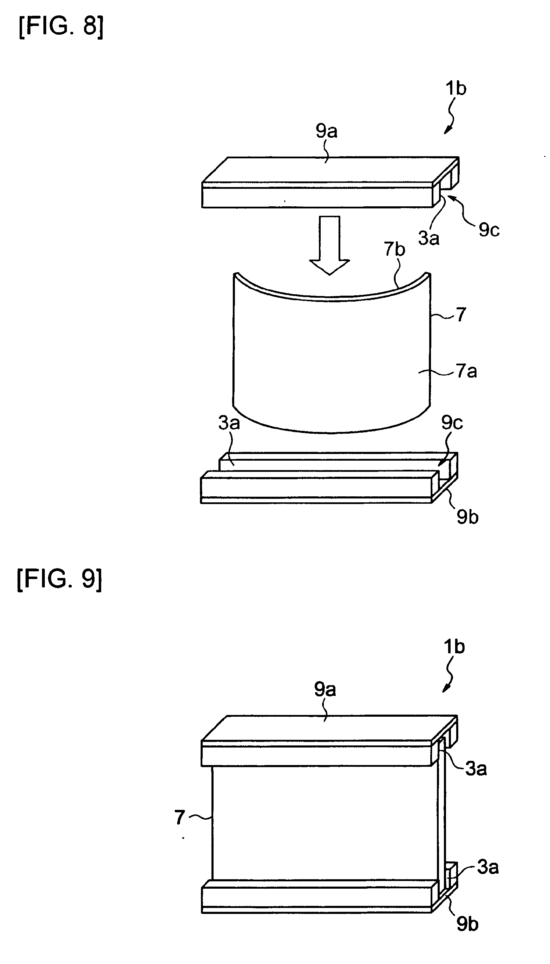

FIG. 8 and FIG. 9 are each a perspective view illustrating an example of the process, in part, used to assemble an organic EL display panel 1b of comparative example 2 which does not form part of the present invention. Note that FIG. 8 and FIG. 9 are simplified views that focus on the members related to the example.

Note that the components of the organic EL display panel 1b of comparative example 2 that are substantially the same as those of comparative example 1 are denoted using same reference numerals as those of FIGS. 1 to 4 of comparative example 1, and descriptions thereof will be omitted. The following description will focus on the differences between the comparative examples.

According to comparative example 2, the film moisture-proof substrate 7, distorted as shown in FIG. 8, is sandwiched by a fixing frame 9a as a frame body from above and a fixing frame 9b as a frame body from below as shown in FIG. 9.

Specifically, these fixing frames 9a and 9b each form a groove 9c, and each of the grooves 9c of the fixing frames 9a and 9b completely sandwich the upper and lower end portions of the film moisture-proof substrate 7. The aforementioned reference surface 3a is formed on the inner peripheral surface of this groove 9c. Note that the reference formed on the inner peripheral surface of the groove 9c may be the aforementioned reference point 3d.

Then, the aforementioned moisture-proof adhesive 6 is filled in these grooves 9c, and these fixing frames 9a and 9b fix the film moisture-proof substrate 7 with the upper and lower end portions of the film moisture-proof substrate 7 sandwiched therebetween. When the moisture-proof adhesive 6 is thus filled inside the grooves 9c, the upper and lower end portions of the film moisture-proof substrate 7 are sealed, making it possible to inhibit the penetration of humidity, moisture, and oxygen therefrom.

In the organic EL display panel 1b of the above comparative example, the frame bodies 9a and 9b each have the groove 9c forming the reference surface 3a, and the moisture-proof fixing means support the end portions of the rectangular film moisture-proof substrate 7 on mutually opposing sides by pressing the end portions of the film moisture-proof substrate 7 so as to perform a close contact with the reference surfaces 3a of the grooves 9c.

With this arrangement, the groove-shaped correcting members 9a and 9b are capable of inhibiting penetration of humidity, moisture, and oxygen from the end portions while the grooves 9c support the end surfaces of the film moisture-proof substrate 7.

### <Alternative example 1 of comparative example 2>

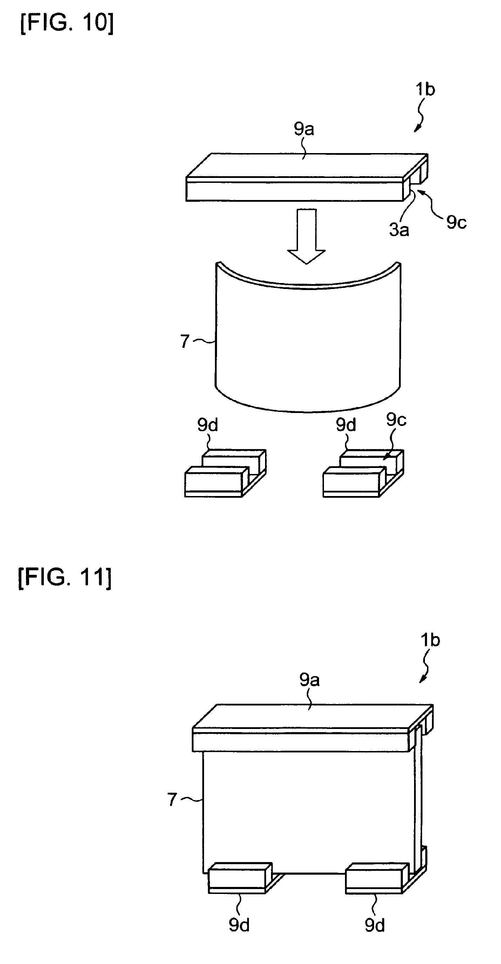

FIG. 10 and FIG. 11 are each a perspective view illustrating an example of the process, in part, used to assemble the organic EL display panel 1 b of alternative example 1 of comparative example 2. Note that FIG. 10 and FIG. 11 are simplified views that focus on the members related to the example.

According to the alternative example 1 of comparative example 2, a fixing frame 9d as a frame body is used in place of the aforementioned fixing frame 9b on the lower side. The fixing frame 9a sandwiches the film moisture-proof substrate 7 in substantially the same manner as described above, and a description thereof will be omitted. The fixing frame 9d differs from the aforementioned fixing frame 9b by the groove 9c. That is, portions of the end portion of the lower side of the film moisture-proof substrate 7 of the example shown in FIG. 10 are sandwiched as illustrated in FIG. 11 to correct the shape.

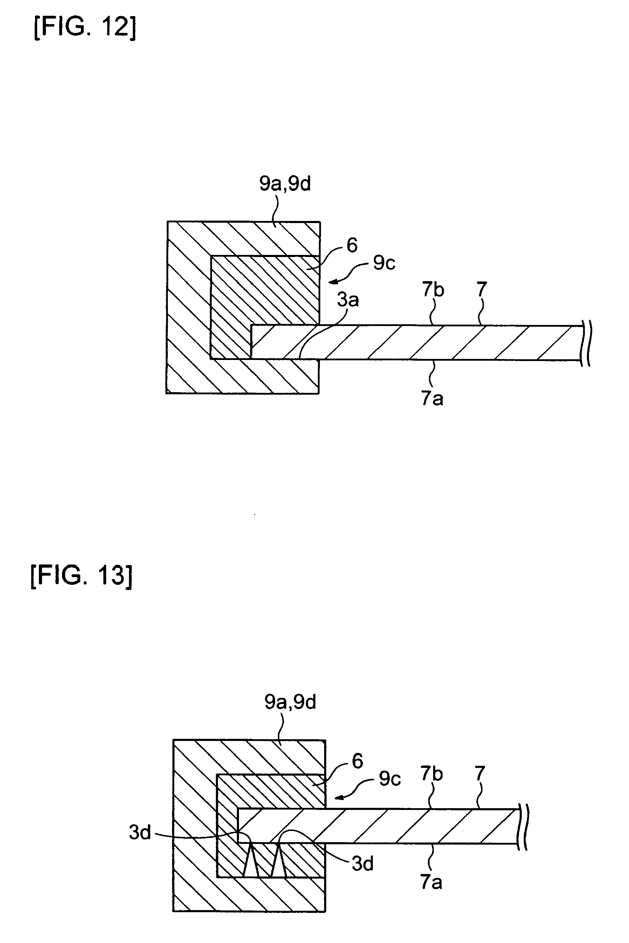

FIG. 12 is a cross-sectional view illustrating a first cross-sectional configuration example of the fixing frames 9a and 9d shown in FIG. 10 and FIG. 11.

As illustrated in FIG. 12, the fixing frames 9a and 9d each form the reference surface 3a within the groove 9c. The reference surface 3a has the function of correcting the shape of the film moisture-proof substrate 7 while in close contact with the film moisture-proof substrate 7 in substantially the same manner as each of the above embodiments. The aforementioned moisture-proof adhesive 6 is filled in the groove 9c, fixing the film moisture-proof substrate 7 disposed within the groove 9c and inhibiting the penetration of humidity, moisture, and oxygen from the end portions thereof.

FIG. 13 is a cross-sectional view illustrating a second cross-sectional configuration example of the fixing frames 9a and 9d shown in FIG. 10 and FIG. 11.

As illustrated in FIG. 13, the fixing frame 9a forms the reference points 3d within the groove 9c. The reference points 3d have the function of correcting the shape of the film moisture-proof substrate 7 in substantially the same manner as each of the above embodiments. The aforementioned moisture-proof adhesive 6 is filled in the groove 9c, fixing the film moisture-proof substrate 7 disposed within the groove 9c and inhibiting the penetration of humidity, moisture, and oxygen from the end portions thereof.

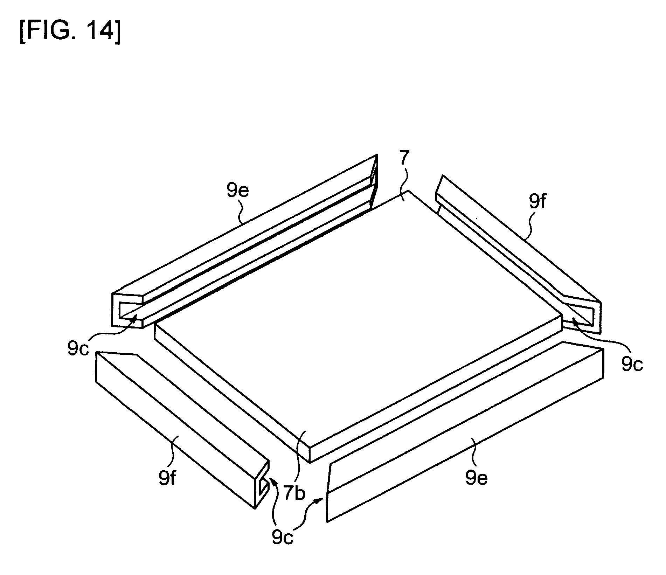

FIG. 14 is a perspective view illustrating an example of fixing the end portions of the film moisture-proof substrate 7 using fixing frames 9e and 9f. Note that FIG. 14 is a simplified view that focuses on the members related to the embodiment.

The mutually opposing sides of the four sides of the rectangular film moisture-proof substrate 7 are respectively supported by the fixing frames 9e and 9f. The fixing frames 9e and 9f as frame bodies have substantially the same configuration as the aforementioned fixing frames 9a and 9b. According to each of these fixing frames 9e and 9f, the reference surface 3a or the reference point 3d is formed within the groove 9c, and the groove 9c is filled with the moisture-proof adhesive 6 with the film moisture-proof substrate 7 sandwiched therebetween.

### <Alternative example 2 of comparative example 2>

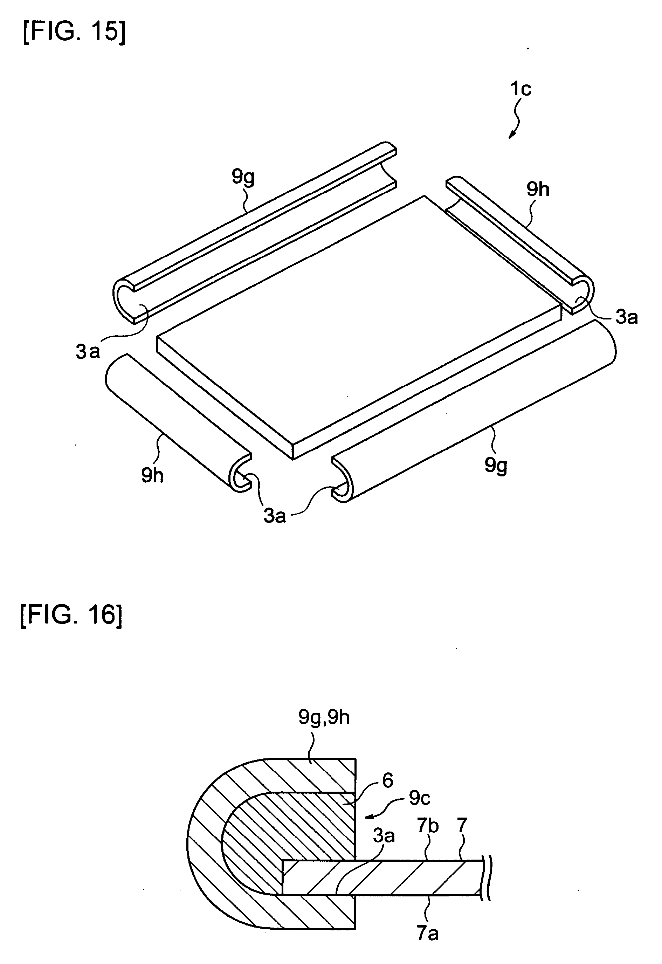

FIG. 15 is a perspective view illustrating an example of the process, in part, used to assemble an organic EL display panel 1c of alternative example 2 of comparative example 2, and FIG. 16 is a cross-sectional view illustrating a configuration example of fixing frames 9g and 9h of FIG. 15. Note that FIG. 15 is a simplified view that focuses on the members related to the example.

In the alternative example 2 of comparative example 2, descriptions of the shapes that are substantially the same as those in the above alternative example 1 of comparative example 2 will be omitted, and the focus will be placed on the differences between the examples. According to the alternative example 2 of comparative example 2, the fixing frames 9e and 9f are each changed to a half-cylindrical shape, as illustrated by the frames 9g and 9h.

Specifically, the cross-sectional shapes of the aforementioned fixing frames 9e and 9f are changed into shapes having extended substantially semicircular end portions, forming the fixing frames 9g and 9h as illustrated in FIG. 16. The extended sections form the above-described reference surface 3a, etc. The fixing frames 9g and 9h as frame bodies are materials similar to the above fixing frames 9e and 9f, and similarly exhibit a moisture-proof effect.

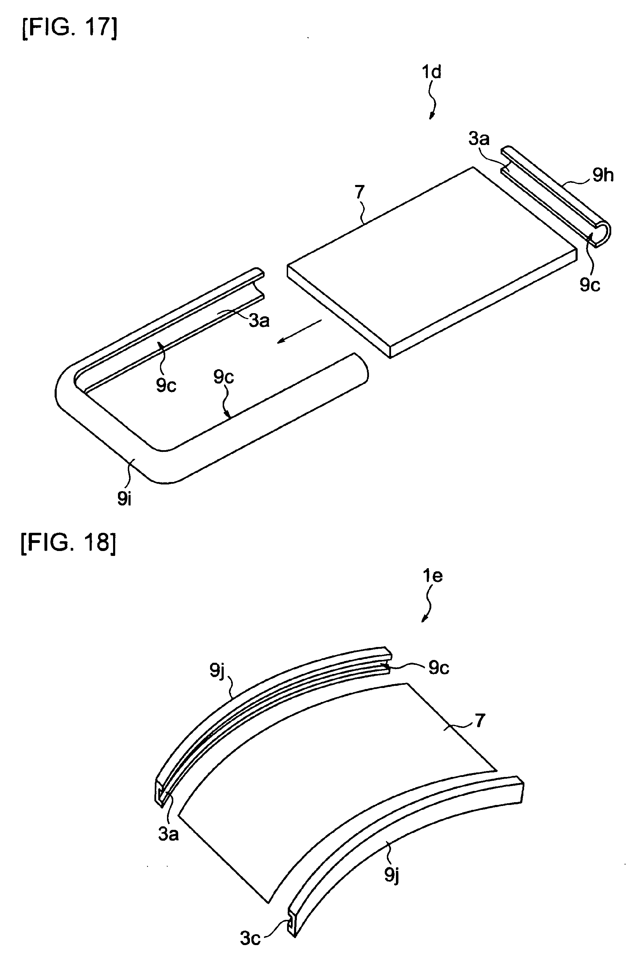

Note that the fixing frames 9g and 9h may be designed so that the fixing frame 9g of two sides and the fixing frame 9h of one side are substantially integrated. Specifically, for example, the film moisture-proof substrate 7 may be inserted in the groove 9c of a U-shaped fixing frame 9i as illustrated in FIG. 17. The four sides of the film moisture-proof substrate 7 are then sandwiched by the fixing frames 9h and 9i as frame bodies. The reference surface 3a is formed on these fixing frames 9h and 9i. The moisture-proof adhesive 6 is filled in the grooves 9c of the fixing frames 9h and 9i with the film moisture-proof substrate 7 in close contact with the reference surface 3a, thereby fixing the film moisture-proof substrate 7 while correcting it according to the reference surface 3a.

### Comparative example 3

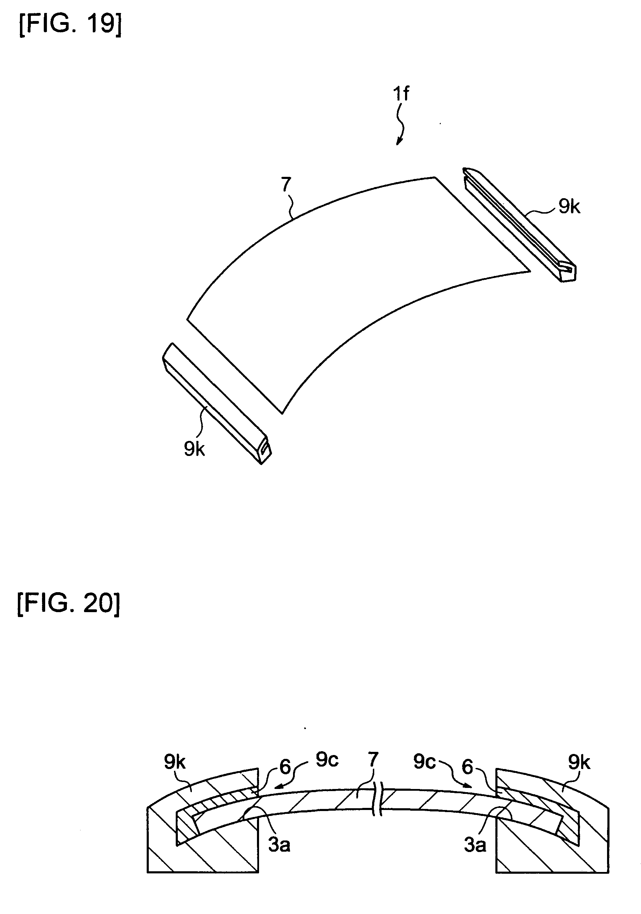

FIG. 18 and FIG. 19 are each a perspective view illustrating an example of the process, in part, used to assemble an organic EL display panel 1e of comparative example 3 which does not form part of the present invention. Note that FIG. 18 is a simplified view that focuses on the members related to the example.

Note that the components of the organic EL display panel 1e of comparative example 3 that are substantially the same as those of embodiments 1 to 3 are denoted using same reference numerals as those in FIG. 1 to FIG. 17 of comparative example 1, and descriptions thereof will be omitted. The following description will focus on the differences between the examples.

While comparative examples 1 and 2 and embodiment 1 each described an illustrative scenario in which the film moisture-proof substrate 7 is corrected to a flat surface, comparative example 3 describes an illustrative scenario in which the film moisture-proof substrate 7 is corrected to a curved surface of a desired curvature.

Specifically, a fixing frame 9j as a frame body comprises a groove 9c that forms a desired curve, as illustrated in FIG. 18. The cross-sectional shape of this groove 9c is substantially the same as that in the above embodiments 1 to 3. and a description thereof will be omitted. The fixing frame 9j has a configuration that makes it possible to sandwich an end portion of the film moisture-proof substrate 7 in the longitudinal direction by the groove 9c. When the film moisture-proof substrate 7 is thus sandwiched by the groove 9c, the fixing frame 9j corrects the film moisture-proof substrate 7 so that it forms a predetermined curved surface along the reference surface 3a of the groove 9c.

FIG. 19 is a perspective view illustrating an example of the process, in part, used to assemble an organic EL display panel 1f of an alternative example of comparative example 3, and FIG. 20 is a cross-sectional view illustrating a cross-sectional configuration example of a fixing frame 9k of FIG. 19. Note that FIG. 19 and FIG. 20 are simplified views that focus on the members related to the example.

The sandwiched sections of the film moisture-proof substrate 7 are not limited to the end portions along the longitudinal direction such as illustrated in FIG 18, allowing use of the end portions along the shorter direction that is substantially perpendicular to the longitudinal direction, as illustrated in FIG. 19. Specifically, a plurality of the fixing frames 9k as frame bodies that form the groove 9c similar to the fixing frame 9j may sandwich the end portions of two sides along the shorter direction.

At this time, with the reference surface 3a of the groove 9c in close contact with and supporting the film moisture-poof substrate 7, thereby correcting the film moisture-proof substrate 7 to a desired curved surface as illustrated in FIG. 20, the film moisture-proof substrate 7 is fixed to the fixing frames 9k by the moisture-proof adhesive 6. With this arrangement, the end portions of the film moisture-proof substrate 7 are sealed by the moisture-proof adhesive 6 to inhibit penetration of humidity, moisture, and oxygen. In addition, according to the configuration shown in FIG. 20, it is possible to match the curvature of the film moisture-proof substrate 7 with the curvature of the reference surface 3a of the fixing frame 9k.

### Comparative example 4

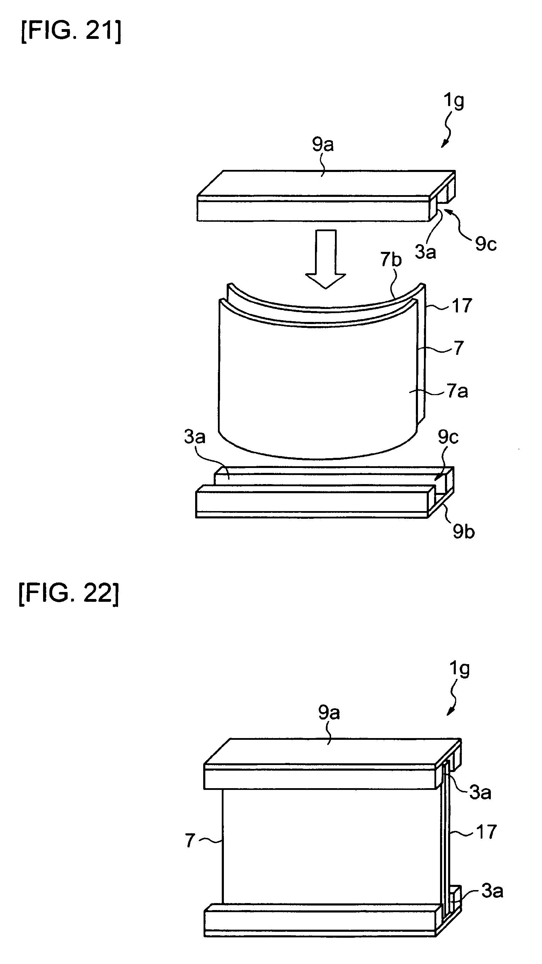

FIG. 21 and FIG. 22 are each a perspective view illustrating an example of the process, in part, used to assembly an organic EL display panel 1g of comparative example 4. Note that FIG. 21 and FIG. 22 are simplified views that focus on the members related to the example

Note that the components of the organic EL display panel 1g of comparative example 4 that are substantially the same as those of comparative example 2 are denoted using same reference numerals as those in FIG. 1 to FIG. 13 of comparative example 2, and descriptions thereof will be omitted. The following description will focus on the differences between the examples.

While comparative example 2 has one film moisture-proof substrate 7 (single substrate), comparative example 4 differs from comparative example 2 in that it has two film moisture-proof substrates 7 and 17. Note that the film moisture-proof substrate 7 of comparative example 4 has substantially the same configuration as that of the film moisture-proof substrate 7 of the above comparative example 2. In addition, the film moisture-proof substrates 7 and 17 may be pasted together, or may be a plurality of substrates that are not pasted together.

The film moisture-proof substrate 17 is a substrate that is equivalent to the other film moisture-proof substrate, having, for example, a moisture-proof action, and comprises a function of protecting the film moisture-proof substrate 7 from humidity, moisture, and oxygen. This film moisture-proof substrate 17 thus exhibits moisture-proof characteristics, but does not have the aforementioned thin-film organic electroluminescent elements, unlike the film moisture-proof substrate 7. In the case of an organic EL, the sealing plate of the fixing and sealing process corresponds to 17.

The film moisture-proof substrate 17 is provided along the front surface of the film moisture-proof substrate 7. With the film moisture-proof substrate 7 and the film moisture-proof substrate 17 thus superimposed, the upper and lower end portions thereof are supported by the fixing frames 9a and 9b as frame bodies, respectively. At this time, the upper and lower end portions are corrected by the reference surface 3a provided to both the fixing frames 9a and 9b and, as a result, the film moisture-proof substrate 7 and the film moisture-proof substrate 17 are corrected to a desired shape.

Examples of the material used for the moisture-proof film of the film moisture-proof substrate 7 and the film moisture-proof substrate 17 mainly include inorganic silicon films, such as SiON, SiO₂, SiN, and SiOC. The moisture-proof film formation method used may be a vacuum thin film coating method, such as spattering or CVD, for example. According to this example, a substrate having a moisture-proof function is formed by forming a moisture-proof film on a film substrate. According to such a configuration, it is possible to inhibit the penetration of moisture and oxygen from both the front and rear surfaces of the formed substrate. Note that the aforementioned surface 3a contacts this moisture-proof film.

In addition, the film moisture-proof substrate 7 and the film moisture-proof substrate 17 may be bonded together using an adhesive, for example. Examples of the adhesive used include an acrylic or epoxy that is based on thermal or UV (ultraviolet light) curing, similar to that used when adhering the fixing plates 9a and 9b, for example. While this example describes an illustrative scenario in which a plurality of substrates (the film moisture-proof substrate 7 and the film moisture-proof substrate 17) is employed, a process technique referred to as solid sealing may be mainly used to seal the substrates and sealing plates in organic EL display panel applications.

The organic EL display panel 1g of the above example, in addition to the above configuration, further comprises another film moisture-proof substrate 17 provided along the front surface of the film moisture-proof substrate 7. wherein the moisture-proof fixing means fixes the other film moisture-proof substrate 17 the film moisture-proof substrate 7 to the frame bodies 9a, 9b in a state that the other film moisture-proof substrate 17 and the film moisture-proof substrate 7 are superimposed.

With this arrangement, since the film moisture-proof substrate 17 is provided on the front surface of the film moisture-proof substrate 7, the film moisture-proof substrate 7 is capable of inhibiting the penetration of humidity, moisture, and oxygen from the end portions as well as the front surface of the film moisture-proof substrate 7. In addition, the film moisture-proof substrate 7 is corrected in accordance with the reference surface 3a along with the other film moisture-proof substrate 17.

### <Alternative example of comparative example 4>

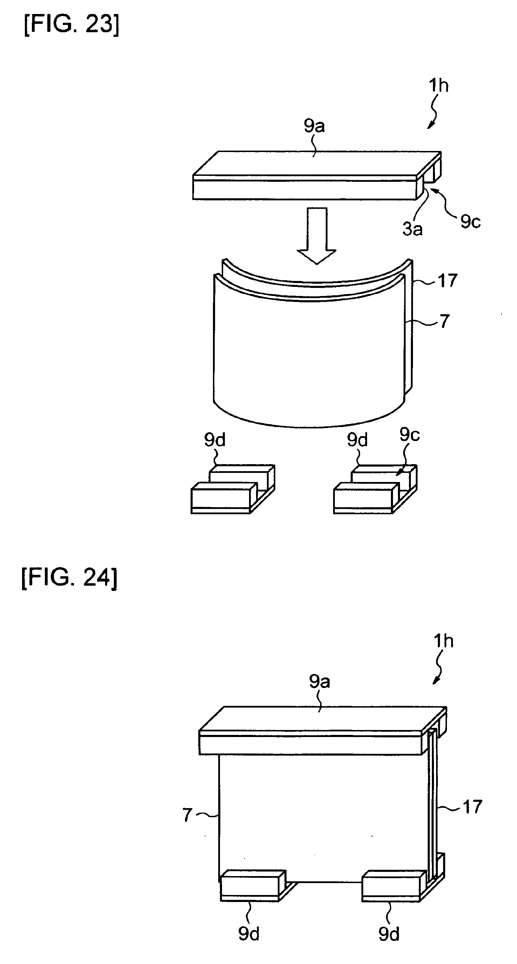

FIG. 23 and FIG. 24 are each a perspective view illustrating an example of the process, in part, used to assemble an organic EL display panel 1h of an alternative example of comparative example 4. Note that FIG. 23 and FIG. 24 are simplified views that focus on the members related to the example.

According to the alternative example of comparative example 4, the fixing frames 9d as a frame body are used in place of the aforementioned fixing frame 9b on the lower side. The fixing frame 9a sandwiches the film moisture-proof substrate 7 in substantially the same manner as described above, and a description thereof will be omitted. This fixing frames 9d differ from the aforementioned fixing frames 9b by the groove 9c. That is, portions of the lower end portion of the film moisture-proof substrate 7 of the example shown in FIG. 23 are sandwiched as illustrated in FIG. 24.

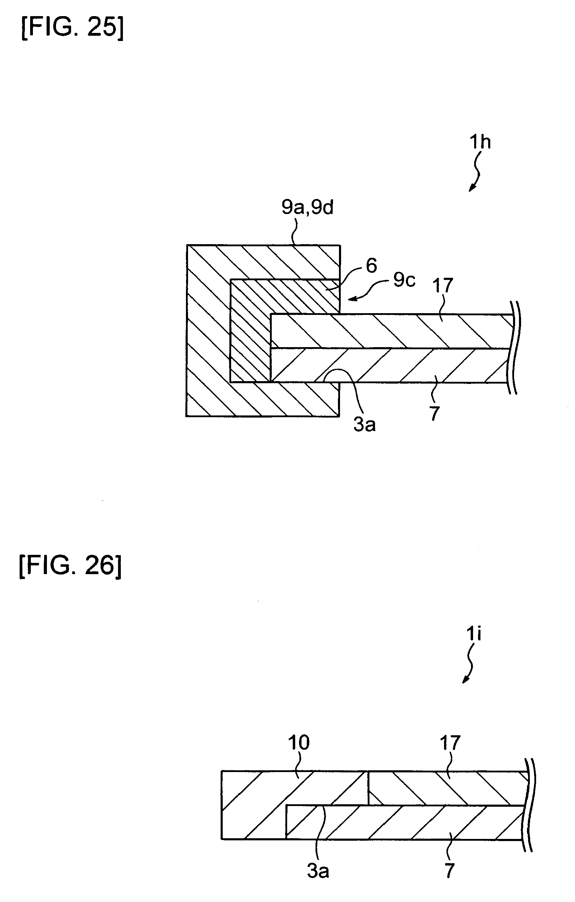

FIG. 25 is a cross-sectional view illustrating a cross-sectional configuration example of the fixing frames 9a and 9d shown in FIG. 23 and FIG. 24.

As illustrated in FIG. 25, the fixing frames 9a and 9d each form the reference surface 3a within the groove 9c. The reference surface 3a has the function of correcting the shape of the film moisture-proof substrate 7 in substantially the same manner as each of the above examples. The aforementioned moisture-proof adhesive 6 is filled in the groove 9c, fixing the film moisture-proof substrate 7 disposed within the groove 9c and inhibiting the penetration of humidity, moisture, and oxygen from the end portions thereof.

With this arrangement, the film moisture-proof substrate 7 is fixed to fixing frames 9a and 9d along with the film moisture-proof substrate 17 while in close contact with the reference surface 3a, using the moisture-proof adhesive 6. This makes it possible to prevent the film moisture-proof substrate 17 from separating from the film moisture-proof substrate 7.

Note that various modifications are possible. In the following, details of such modifications will be described one by one.

### Alternative example 1

FIG. 26 is a cross-sectional view illustrating a configuration example of a portion of an organic EL display panel 1i of alternative example 1 of the comparative example 4. Note that in alternative example 1 a description will be omitted for those components that are substantially the same as those of each of the above-described examples, and the focus will be placed on the differences from each of the comparative example 4.

According to alternative example 1, the film moisture-proof 7 is fixed to a fixing frame 10 (equivalent to a moisture proof fixing member) while superimposed on the film moisture-proof substrate 17, similar to the above comparative example 4. The combined thickness of the film moisture-proof substrate 7 and the film moisture-proof substrate 17 is substantially the same as the thickness of the fixing frame 10. A slight difference in surface area exists between the film moisture-proof substrate 7 and the film-moisture proof substrate 17. The section formed by this surface area difference is in close contact with the fixing frame 10, which has the reference surface 3a that is substantially the same as in each of the above embodiments.

According to the alternative example 1, the surface area of the film moisture-proof substrate 17 is smaller than the surface area of the film moisture-proof substrate 7, and the surface of a portion of the film moisture-proof substrate 7 is in close contact with the reference surface 3a of the fixing frame 10. The fixing frame 10 has a moisture-proof function that inhibits humidity and moisture and an oxygen permeation control function. The reference surface 3a, similar to each of the above examples, has the function of correcting the film moisture-proof substrate 7 so that it forms a desired shape.

In addition, this fixing frame 10 is mainly disposed on the side of the film moisture-proof substrate 7 and the film moisture-proof substrate 17 to cover the end potions thereof, thereby inhibiting the penetration of humidity, moisture, and oxygen from the end portions.

In the organic EL display panel 1i of the alternative example 1, in addition to the above configuration, the moisture-proof fixing member comprises the reference surface 3a that is in close contact the section of the bonded film moisture-proof substrate 7 and the film moisture-proof substrate 17 where there is a difference in surface area, and the fixing member body 10 (equivalent to the fixing frame) that fixes the film moisture - proof substrate 7 and the other film moisture-proof substrate 17 in a superimposed state.

J With this arrangement, the reference surface 3a of the fixing member body 10 is capable of correcting the film moisture-proof substrate 7 and the other film moisture-proof substrate 17 to a desired shape, and the fixing member body 10 is capable of exhibiting a moisture-proof effect that inhibits the penetration of humidity and moisture from each end portion of the film moisture-proof substrate 7 and the other film moisture-proof substrate 17 as well as decreasing the size in the thickness direction.

The organic EL display panel 1i of the above example comprises a configuration wherein, in addition to the above configuration, the thickness of the fixing member body 10 is substantially equal to the combined thickness of the superimposed film moisture-proof substrate 7 and the other film moisture-proof substrate 17.

With this arrangement, the thickness of the fixing member body 10 is equal to the thickness of the film moisture-proof substrate 7 and the other film moisture-proof substrate 17, thereby making it possible to flatten the area from the fixing member body 10 to the front surface of the film moisture-proof substrate 7 or the other film moisture-proof substrate 17. This makes it possible to achieve the thinness demanded in a film EL.

### Alternative example 2

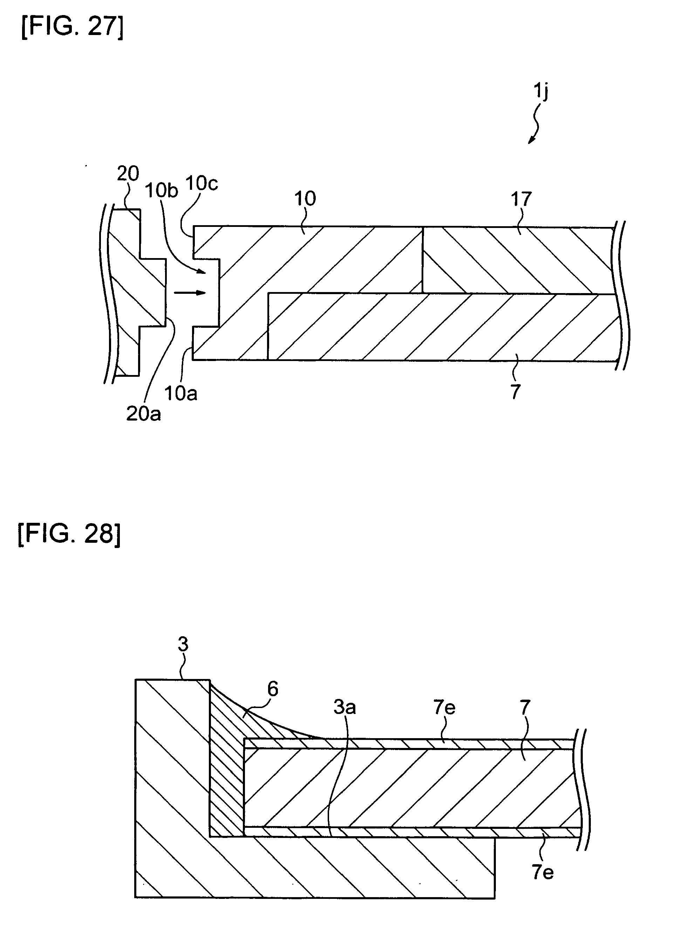

FIG. 27 is a cross-sectional view illustrating a configuration example of a portion of an organic EL display panel 1j of alternative example 2, which is a further modification of the alternative example 1. In alternative example 2, the configuration is substantially the same as that of alternative example 1, but the shape of the fixing member body 10 differs as follows.

A second joining portion 10b of a groove shape is formed on a side surface 10c of the fixing member body 10 of the above alternative example 1. On the other hand, a first joining portion 20a of a convex shape is formed on a
display device body 20 that emits light from the film moisture-proof substrate 7 to display a desired image. This first joining portion 20a is designed to mate with the second joining portion 10b. When the first joining portion 20a is thus mated with the second joining portion 10b, the film moisture-proof substrate 7 and the film moisture-proof substrate 17 are fixed to the fixing frame body 10 and the display device body 20.

The moisture permeability of the fixing member body 10 is, for example, greater than or equal to 0.01 [g/m² per day] and less than or equal to 100 [g/m² per day]. In addition, the material used for the fixing member body 10 is, for example, a moisture-proof insulating material made by Hitachi Chemical to protect the end portions of the film moisture-proof substrate 7 and the like. Note that this moisture-proof insulating material is often employed as a material for a flat panel display, for example. In the fixing member body 10, the second joining portion 10b is bonded to the first joining portion 20a using the adhesive 6 that is of an ultraviolet curing or thermal curing type, for example.

In the organic EL display panel 1j of the above alternative example, in addition to the above configuration, the second joining portion 10b that mates with the first joining portion 20a of the display device body 20 that emits light from the film moisture-proof substrate 7 to display a desired image is formed on the fixing member 10.

ith this arrangement, the first joining portion 20a and the second joining portion 10b join together and correct the film moisture-proof substrate 7 in such a manner that the reference surface 3a minimizes the deformation thereof in the event the organic EL display panel 1j is subjected to impact when mounted on the display device body 20 causing deformation of the film moisture-proof substrate 7.

The organic EL display panel Ij of the above alternative example comprises a configuration wherein, in addition to the above configuration, the coefficients of linear expansion of the film moisture-proof substrate 7, the other film moisture-proof substrate 17, and the fixing member body 10 are substantially equal.

With this arrangement, the fixing member body 10 shapes the film moisture-proof substrate 7 and the other film moisture-proof substrate 17 in substantially the same manner, even if the film moisture-proof substrate 7 and the other film moisture-proof substrate 17 have deformed over time, thereby making the film moisture-proof substrate 7, the other film moisture-proof substrate 17, and the fixing member body 10 expand substantially in the same manner if moisture is absorbed. As a result, the organic EL display panel 1j is capable of minimizing the effect caused by a difference in expansion due to deformation over time of the film moisture-proof substrate 7, the other film moisture-proof substrate 17, and the fixing member body 10.

In the organic EL display panel 1j of the above alternative example, in addition to the above configuration, the moisture permeability of the fixing member body 10 is greater than or equal to 0.01 [g/m² per day] and less than or equal to 100 [g/m² per day], for example.

With this arrangement, a moisture-proof effect of the end portions of the film moisture-proof substrate 7 is sufficiently exhibited, making it possible to improve the reliability of the organic EL display panel 1j.

The organic EL display panel 1 to 1h of each of the above comparative examples, in addition to the above configuration, may further comprise the fixing member body 10 that fixes a side of the film moisture-proof substrate 7. That is, the above fixing member body 10 may fix the film moisture-proof substrate 7 that is not provided with such the film moisture-proof substrate 17, from the side.

In the organic EL display panel 1 to 1h of each of the above embodiments and examples, in addition to the above configuration, the second joining portion 10b that mates with the first joining portion 20a of the display device body 20 that emits light from the film moisture-proof substrate 7 to display a desired image is formed on the fixing member body 10.

With this arrangement, the first joining portion 20a and the second joining portion 10b join together and correct the film moisture-proof substrate 7 in such a manner that the reference surface 3a minimizes the deformation thereof in the event the organic EL display panels 1 to 1h are subjected to impact when mounted on the display device body 20 causing deformation of the film moisture-proof substrate 7.

The organic EL display panel 1 to 1h of each of the above embodiments comprises a configuration wherein, in addition to the above configuration, the linear coefficients of expansion of the film moisture-proof substrate 7 and the fixing member body 10 are substantially equal.

With this arrangement, the fixing member body 10 changes shape in substantially the same manner as the film moisture-proof substrate 7, even if the film moisture-proof substrate 7 has deformed over time, causing the film moisture-proof substrate 7 and the fixing body 10 to expand substantially in the same manner if moisture is absorbed. As a result, the organic EL display panels 1 to 1h are each capable of minimizing the effect caused by the difference in expansion due to deformation over time of the film moisture-proof substrate 7 and the fixing member body 10.

In the organic EL display panels 1' to 1h of each of the above embodiment and examples, in addition to the above configuration, the moisture permeability of the fixing member body 10 is greater than or equal to 0.01 [g/m² per day], for example.

With this arrangement, a moisture-proof effect of the end portions of the film moisture-proof substrate 7 is sufficiently exhibited, making it possible to improve the reliability of each of the organic EL display panels 1 to 1h.

FIG. 28 is a partial cross-sectional view illustrating an alternative example embodiment of the film moisture-proof substrate 7 of FIG. 3. In FIG. 28, the components are substantially the same as those of FIG. 3 of comparative example 1. Descriptions of identical components will therefore be omitted, and the focus will be placed on the differences between the embodiments.

On both surfaces of the film moisture-proof substrate 7, a moisture-proof film 7e is provided as an example of the other film moisture-proof substrate. This moisture-proof film 7e is an inorganic film, for example, and has a moisture-proof function similar to that of the aforementioned film moisture-proof substrate 17. The moisture-proof films 7e of both surfaces are formed on both surfaces of the film moisture-proof substrate 7. The film moisture-proof substrate 7 is fixed to the frame body 3 using the moisture-proof adhesive 6, with the moisture-proof film 7e in contact with the reference surface 3a. With this arrangement, it is possible to prevent separation of the moisture-proof film 7e.

In the organic EL display panel 1j, etc., of the above embodiment, comparative examples and alternative examples, in addition to the aforementioned configurations, the other film moisture-proof substrate may serve as the moisture-proof film 7e formed on the front and rear surfaces of the film moisture-proof substrate 7.

With this arrangement, the film moisture-proof substrate 7 is capable of exhibiting a moisture-proof effect that inhibits penetration of humidity and moisture from the end portions thereof, as well as exhibiting a moisture-proof effect that inhibits penetration of humidity and moisture from the front and rear surfaces thereof.

Each of the above embodiment, comparative examples and alternative examples may be applied, for example, to film devices, in general. Such general applicable film devices include, for example, organic electroluminescent displays, organic transistors, organic solar cells, semiconductor lasers, and CNT-FET transistors.

## Claims

1. An organic electroluminescent display panel (1a), comprising:
a frame body (3) on which a desired reference surface (3a) is formed;
a film moisture-proof substrate (7) having a built-in thin-film organic electroluminescent element group; and
moisture-proof fixing means (6,9) for fixing a front surface (7a) of said film moisture-proof substrate (7) to said frame body (3) while said front surface (7a) of said film moisture-proof substrate (7) is in close contact with said reference surface (3a), and for covering at least an end portion of said film moisture-proof substrate(7), **characterized in that**:
said moisture-proof fixing means (6,9) includes:
an adhesive (6) for fixing said film moisture-proof substrate (7) to said frame body (3) while said film moisture-proof substrate (7) is in close contact with said reference surface (3a); and
a pressing and fixing frame (9) that presses against a rear surface (7b) of said film moisture-proof substrate (7) so that said film moisture-proof substrate (7) comes in close contact with said reference surface (3a).

2. A manufacturing method of an organic electroluminescent display panel comprising
a step for fixing a front surface (7a) of a film moisture-proof substrate (7) having a built-in thin-film organic electroluminescent element group to a frame body (3) in a state that a pressing and fixing frame (9) presses against a rear surface (7b) of said film moisture-proof substrate (7) so that said film moisture-proof substrate (7) comes in close contact with a reference surface (3a) formed on a frame body (3), while covering at least an end portion of said film moisture-proof substrate (7) by using the pressing and fixing frame (9) in a pressing state and an adhesive (6).

## Patentansprüche

1. Organischer Elektrolumineszenz-Anzeigebildschirm (1a), der Folgendes umfasst:
einen Rahmenkorpus (3), an dem eine gewünschte Bezugsfläche (3a) geformt ist,
ein feuchtigkeitsbeständiges Foliensubstrat (7), das eine eingebaute organische Dünnschicht-Elektrolumineszenzelement-Gruppe hat, und
feuchtigkeitsbeständige Befestigungsmittel (6, 9), um eine vordere Fläche (7a) des feuchtigkeitsbeständigen Foliensubstrats (7) an dem Rahmenkorpus (3) zu befestigen, während sich die vordere Fläche (7a) des feuchtigkeitsbeständigen Foliensubstrats (7) in einer engen Berührung mit der Bezugsfläche (3a) befindet, und um wenigstens einen Stirnabschnitt des feuchtigkeitsbeständigen Foliensubstrats (7) abzudecken, **dadurch gekennzeichnet, dass**:
die feuchtigkeitsbeständigen Befestigungsmittel (6, 9) Folgendes einschließen:
einen Klebstoff (6), um das feuchtigkeitsbeständige Foliensubstrat (7) an dem Rahmenkorpus (3) zu befestigen, während sich das feuchtigkeitsbeständige Foliensubstrat (7) in einer engen Berührung mit der Bezugsfläche (3a) befindet, und
einen Druck- und Befestigungsrahmen (9), der gegen eine hintere Fläche (7b) des feuchtigkeitsbeständigen Foliensubstrats (7) drückt, so dass das feuchtigkeitsbeständige Foliensubstrat (7) in eine enge Berührung mit der Bezugsfläche (3a) kommt.

2. Verfahren zur Herstellung eines organischen Elektrolumineszenz-Anzeigebildschirms, das Folgendes umfasst:
einen Schritt für das Befestigen einer vorderen Fläche (7a) eines feuchtigkeitsbeständigen Foliensubstrats (7), das eine eingebaute organische Dünnschicht-Elektrolumineszenzelement-Gruppe hat, an einem Rahmenkorpus (3) in einem Zustand, in dem ein Druck- und Befestigungsrahmen (9) gegen eine hintere Fläche (7b) des feuchtigkeitsbeständigen Foliensubstrats (7) drückt, so dass das feuchtigkeitsbeständige Foliensubstrat (7) in eine enge Berührung mit der Bezugsfläche (3a) kommt, die an einem Rahmenkorpus (3) geformt ist, wobei durch die Verwendung des Druck- und Befestigungsrahmens (9) in einem Druckzustand und eines Klebstoffs (6) wenigstens ein Stirnabschnitt des feuchtigkeitsbeständigen Foliensubstrats (7) abgedeckt wird.

## Revendications

1. Panneau d'affichage électroluminescent organique (1a), comprenant :
un corps de cadre (3) sur lequel est formée une surface de référence souhaitée (3a) ;
un substrat en film résistant à l'humidité (7) comportant un groupe d'éléments électroluminescents organiques en couches minces incorporés ; et
des moyens de fixation résistant à l'humidité (6, 9) permettant de fixer une surface avant (7a) dudit substrat en film résistant à l'humidité (7) audit corps de cadre (3) tandis que ladite surface avant (7a) dudit substrat en film résistant à l'humidité (7) est en contact étroit avec ladite surface de référence (3a), et de couvrir au moins une portion d'extrémité dudit substrat en film résistant à l'humidité (7), **caractérisé en ce que** :
lesdits moyens de fixation résistant à l'humidité (6, 9) comportent :
un adhésif (6) permettant de fixer ledit substrat en film résistant à l'humidité (7) audit corps de cadre (3) tandis que ledit substrat en film résistant à l'humidité (7) est en contact étroit avec ladite surface de référence (3a) ; et
un cadre de fixation et de pression (9) qui appuie contre une surface arrière (7b) dudit substrat en film résistant à l'humidité (7) de sorte que ledit substrat en film résistant à l'humidité (7) vient en contact étroit avec ladite surface de référence (3a).

2. Procédé de fabrication d'un panneau d'affichage électroluminescent organique comprenant
une étape consistant à fixer une surface avant (7a) d'un substrat en film résistant à l'humidité (7) comportant un groupe d'éléments électroluminescents organiques en couches minces incorporés à un corps de cadre (3) dans un état tel qu'un cadre de fixation et de pression (9) appuie contre une surface arrière (7b) dudit substrat en film résistant à l'humidité (7) de sorte que ledit substrat en film résistant à l'humidité (7) vient en contact étroit avec une surface de référence (3a) formée sur un corps de cadre (3), tout en couvrant au moins une portion d'extrémité dudit substrat en film résistant à l'humidité (7) en utilisant le cadre de fixation et de pression (9) dans un état de pression et un adhésif (6).
